# EUROPEAN PATENT APPLICATION

(11) **EP 2 367 287 A2**
(43) Date of publication of application: **21.09.2011**
(21) Application number: 10197304.8
(22) Date of filing: 29.12.2010
(51) Int. Cl.: H03G 3/32

(54) **Automatic correction of loudness level in audio signals**

(30) Priority: 12.03.2010 EP 10156409
(71) Applicant: Harman Becker Automotive Systems GmbH, 76307 Karlsbad (DE)
(72) Inventor: Hess, Wolfgang, 76307 Karlsbad (DE); Bähren, Frank, 75181 Pforzheim (DE)
(74) Representative: Bertsch, Florian Oliver

(57) **Abstract**

The present invention relates to a method for adapting a gain of an audio output signal containing at least two different tracks with different signal level ranges, the method comprising the steps of:
- dynamically determining a perceived loudness of an audio input signal based on a psychoacoustic model of a human,
- dynamically determining a gain of the audio output signal output by a gain determination unit (35) receiving the perceived loudness and outputting the audio output signal with the determined gain, wherein the gain is determined in such a way that said at least two tracks of the audio output signal are output covering a predetermined range of signal levels or loudness range,
- estimating an ambient noise in a space to which the audio output signal is output, and
- determining to which extend the gain determined by the gain determination unit influences the audio output signal, wherein the extend by which an audio output is influenced by the gain determination unit, is determined based on the estimated ambient noise.

## Description

### Technical Field

This invention relates to a method for adapting a gain of an audio output signal containing at least two different tracks with different signal level ranges and the system therefor.

### Background

In the art many different sources of audio signals containing music and/or speech are known. The music signal can be stored on a CD, a DVD or on any other storage medium. Especially with the development of new compression schemes such as MPEG audio signals with different genres and artists are stored on a storage medium and may be combined to a playlist to be played out to a user. Especially in a vehicle environment the audio signals perceived by the passengers contain the audio signal itself and road tire noise, aerodynamics noise and engine noise. The different audio signals of the different audio sources often have different signal and dynamics compression levels. Often, different tracks of an audio output signal have different signal level ranges which are perceived by the user with a different loudness level. Especially in a vehicle environment the received audio signal should be perceivable to the user, meaning that it has to exceed the noise present in the vehicle. At the same time the overall audio signal level should not exceed a certain level where a hearing damage could be generated or where the perception is painful for the user.

Furthermore, in a vehicle environment the ambient noise strongly depends on the vehicle velocity.

### Summary

Accordingly, a need exists to allow a dynamic automatic correction of a loudness level in audio signals in a vehicle at different driving conditions..

This need is met by the features of the independent claims. In the dependent claims preferred embodiments of the invention are described.

According to a first aspect of the invention, a method for adapting a gain of an audio output signal containing at least two different tracks with different signal level ranges is provided. The method comprises the step of determining dynamically a perceived loudness of an audio input signal based on a psycho-acoustic model of the human hearing. Additionally, a gain of the audio output signal output by a gain determination unit receiving the determined loudness and outputting the audio output signal is dynamically determined, wherein the gain is determined in such a way that said at least two tracks of the audio output signal are output within a predetermined range of signal levels. Furthermore, the ambient noise in a space, to which the audio output signal is output, is estimated and it is determined to which extend the gain determined by the gain determination unit influences the audio output signal. The extend by which the audio output signal is influenced by the gain determination unit is then determined based on the estimated ambient noise. If the ambient noise is very low, e.g. when the vehicle is at rest or driving at a very low velocity, the gain adaptation by the gain determination unit is not absolutely necessary. However, at a higher vehicle velocity the dynamically determined gain adaptation can be more useful, as the signal level should be high enough to be perceivable by the user, but not too high. By automatically adapting the output signal level in such a way that different tracks are output within a predetermined range, one equivalent loudness for the different tracks can be obtained. Furthermore, a volume adjustment by the user is not necessary anymore. Especially the reduction of the volume of a track or an audio signal having a high signal pressure level SPL is avoided as well as the increase of the volume in case of an audio signal having a comparably low signal pressure level. Thus, it is possible to have an equivalent loudness of all different audio signal sources while preserving the dynamic structure of the audio signal.

The loudness can be determined using said psycho-acoustic model alone or in combination with signal statistics of the audio input signal.

One possibility to estimate the ambient noise is to determine the vehicle speed in the vehicle in which the audio output signal is output and to deduce the ambient noise from the determined vehicle speed. In this embodiment the exact measurement of the ambient noise via a microphone is not necessary, the ambient noise can be deduced from the vehicle speed. However, it should be understood that as an alternative, a microphone may also be used to estimate the ambient noise. The microphone signal may then be used alone or in combination with the vehicle velocity to estimate the ambient noise.

In one embodiment it is possible that, if the estimated ambient noise is lower than a predefined threshold, the audio output signal may not be influenced by the gain determination unit at all. When the ambient noise, e.g. as determined by the vehicle speed, is low the adaptation of the gain by the gain determination unit might not be necessary, and the audio output signal can be output using the signal level ranges as provided by the audio source. Furthermore, it is possible to increase the extent by which the dynamically determined gain influences the audio output signal with the increase of the ambient noise, i.e. with the increase of the vehicle speed. This means that the higher the vehicle speed, the more the gain determination unit influences the signal level or loudness range of the output signal.

According to a preferred embodiment the method comprises the step of determining a pause between said at least two different tracks or a pause within a track in which noise is the dominant audio input signal. When such a pause with noise is detected, the gain is decreased in the determined pause in order to avoid the amplification of noise. In one embodiment of the invention the noise is detected in the audio input signal by determining whether the input signal can be localized or not using a simulation of the spatial perception of the audio input signal as it would be perceived by a listener listening to the audio input signal based on a binaural localization model. If it is possible to localize the audio input signal using said psycho-acoustical model of the human hearing, then the audio input signal is not considered as being noise. If, however, the audio input signal cannot be localized, then the audio input signal is considered as mainly containing noise. As a consequence, it is possible to avoid the increase of the loudness of an audio signal only containing noise. Preferably, the gain is decreased for a pause if the pause is detected over a predetermined time period, e.g. between 10-100 ms, preferably around 50 ms. Thus, only if a pause is detected for more than e.g. 50 ms, the gain is lowered in order to avoid to lower the gain during a track in which a very short period with no music signal is contained. If the audio input signal however contains more information and the input signal level is quite low, then the gain should be adapted accordingly by increasing the gain in such a way that the audio output signal covers the predetermined range of signal levels. Thus, audio input signals having an audio input level that is too high are lowered by controlling the gain in such a way that the predetermined range of signal levels is covered, and if the input audio level is too low, the gain is increased in order to cover the same range of signal levels. The localization model can be used for pause detection based on the localizability of the input signal. The localization model can additionally be used to estimate the loudness. Normally, audio signals are processed in blocks to save processing time compared to a sample-by-sample processing. According to one embodiment of the invention a gain of each block is determined using a time constant, this time constant describing the change of the loudness from one signal block to the next block. In this embodiment a raising time constant is used to describe a raising signal loudness between two consecutive blocks and a falling time constant is used to describe a falling loudness between two consecutive blocks. A block contains one or several signal samples of the digital audio input signal. Preferably, the time constants are configured in such a way that the raising time constants allow a faster loudness increase than the falling time constant allows a loudness decrease. The fast loudness increase is necessary at the beginning of a new track after a signal pause, where it is necessary to suddenly increase a loudness from one block to the other. The lower possible loudness decrease between two blocks allows to maintain the dynamic of an increased loudness originally contained in the audio signals.

Preferably, the time constant is an adaptive time constant, wherein the adaptive time constant is adapted in such a way that, at the beginning of a track, the time constant is allowed to vary faster than later during the track. This allows a fast adaptation of the loudness at the beginning of a track and helps to nevertheless maintain the dynamic contained in an audio signal, e.g. in a music track. Especially in a music track containing classical music, the dynamic of the signal level as originally contained in the signal should be maintained.

Preferably, the adaptive time constant is reset when a pause between two tracks is detected. It is possible that some users of an audio signal source would like to maintain the dynamic range of the original audio signal without adapting the gain for an adapted loudness.

Furthermore, the audio input signal may be delayed before it is output, the delay corresponding to the time that is needed to determine the adapted gain. This delay may be constant or may vary with the calculation of the adapted gain.

The invention furthermore relates to a system adapting the gain as described above comprising a loudness determination unit dynamically determining the loudness of the audio input signal based on the psycho-acoustic binaural model of the human hearing and eventually based on signal statistics of the music input signal or the combination of both. A gain determination unit is provided in a system receiving the determined loudness, the gain determination unit outputting the music output signal with an adapted gain, wherein the gain determination unit dynamically determines the gain of the music output signal in such a way that said at least two tracks of the audio output signal are output in such a way that they cover a predetermined range of signal levels.

The system furthermore comprises an ambient noise estimation unit configured to estimate an ambient noise in the space to which the audio output signal is output. Furthermore, a gain control unit is provided configured to determine to which extent the gain determined by the gain determination unit influences the audio output signal, wherein the gain control unit determines the extent by which the audio output signal is influenced by the gain determination unit based on the estimated ambient noise. As discussed in connection with the method of the invention above, the ambient noise estimator may use the vehicle velocity to estimate the ambient noise. The gain control unit may disable the influence of the gain determination unit if the ambient noise is lower than a predefined threshold.

The audio analyzing unit determines a pause, as mentioned above, by analyzing the possibility to localize the input signal or by using the signal statistics. The music analyzing unit tries to localize the audio input signal using a simulation of the spatial adaption of the input signal. One embodiment how the localization using the spatial perception of the music input signal as perceived by the listener is described in EP 1 522 868 A1. For further details of the localization reference is made to this document. Further details can also be found in "Acoustical Evaluation of Virtual Rooms by Means of Binaural Activity Patterns" by Wolfgang Hess et al. in Audio Engineering Society Convention Paper 5864, 115th Convention, October 2003. For the localization of signal sources reference is furthermore made to W. Lindemann "Extension of a Binaural Cross-Correlation Model by Contralateral Inhibition. I. Simulation of Lateralization for Stationary Signals", in Journal of Acoustic Society of America, December 1986, p. 1608-1622, Vol. 80 (6).

The audio analyzing unit determines the adaptive time constants as described above and resets them when a pause is detected. Different tracks of the audio signals can be separated by recognizing the content of the different tracks using the pause detection mentioned above.

Furthermore, a delay unit may be present that introduces that delay time in the audio input signal before it is output with the controlled gain. The delay element introduces a delay that corresponds to the delay time needed to determine the adapted gain.

### Brief Description of the Drawings

The invention will be described in further detail with reference to the accompanying drawings, in which
Fig. 1 schematically shows the components of an in-vehicle sound containing noise and audio components,
Fig. 2 shows an example of an audio input signal and the estimated loudness without gain adaptation, including different time constants to smooth loudness, i.e. fast reaction to increasing loudness and retarded reaction at decreasing loudness levels,
Fig. 3 shows a dynamic level adjustment of the audio input signal as it should be adjusted for an automatic loudness adjustment, corrected ideally when the full signal content is known, a -12 average loudness line is shown,
Fig. 4 schematically shows the system used to adapt the gain of the audio output signal,
Fig. 5 shows a more detailed view of an audio analyzing unit that is used to determine the loudness of the audio input signal,
Fig. 6 schematically shows the introduction of time constants into the audio signal representing the gain change from one block to another block,
Fig. 7 shows audio input signal levels without and with automatic loudness adaptation,
Fig. 8 shows another example of an audio input signal before and after automatic loudness adaptation.

### Detailed Description

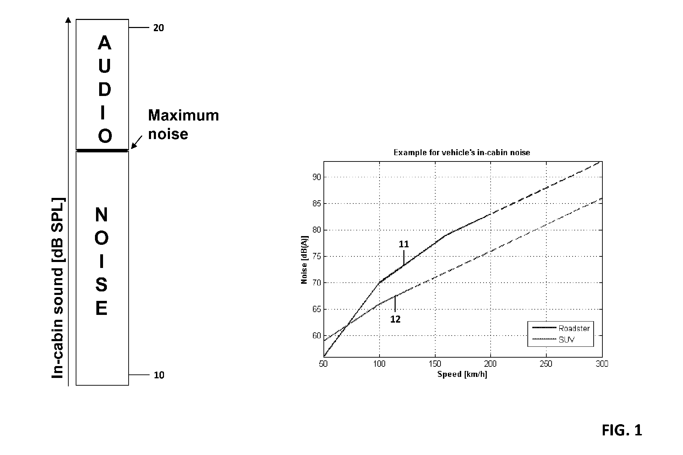

As can be seen from Fig. 1, depending on the vehicle used different ambient noises are perceived by the vehicle's occupants. The vehicle sound signal comprises noise components 10 and an audio signal component 20. The noise signal component 10 may be due to road tire noise, aerodynamic noise, or engine noise. In the right part of Fig. 1 the noise for different vehicles in dependence on the vehicle speed is indicated. Curve 11 describes the noise as generated in a Roadster or sports car, whereas curve 12 shows the speed-dependent noise of a SUV. As can be seen, the noise can have values between 60 and 85 dB SPL (Signal Pressure Level). As the hearing pain threshold is around 120 dB SPL, the range for the audio signal components is within 20-40 dB SPL.

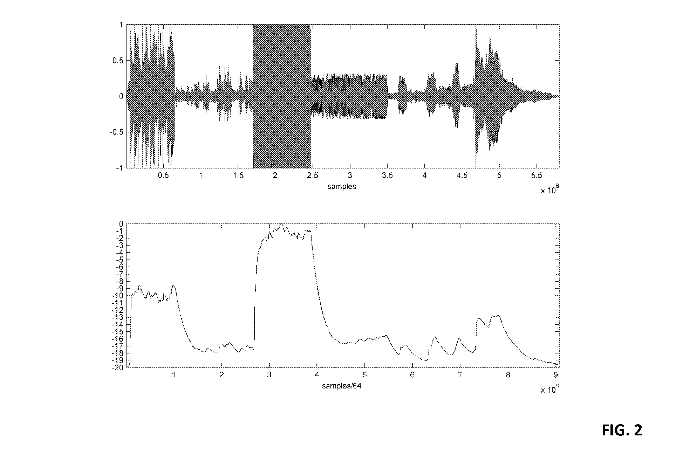

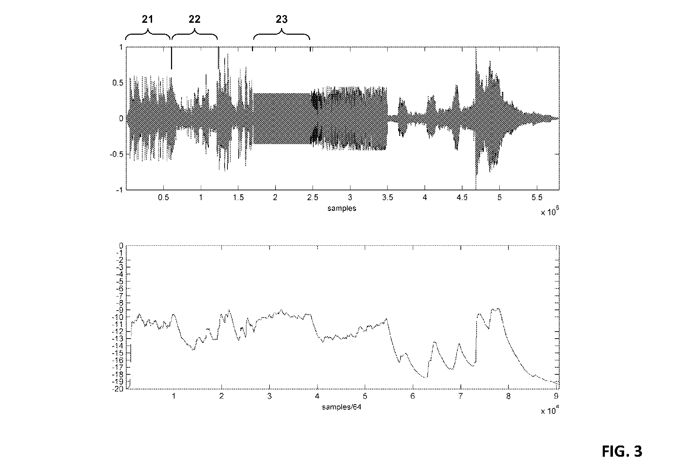

In the upper part of Fig. 2 a signal level of an audio input signal is shown in full scale, meaning that 0 dB full scale (0 dBFS) is assigned to the maximum possible signal level in the digital domain, dB full scale meaning decibels relative to full scale. As can be seen from the upper part of Fig. 2, the signal level and therefore also the loudness level corresponding to the signal as perceived by a user varies considerably. In the lower part of Fig. 2 the corresponding loudness was estimated from the signal input level. One possibility for a loudness estimation is described in Recommendation ITU-R BS. 1770-1 ("Algorithms to Measure Audio Program Loudness and to a Peak Audio Level"). In the present application loudness may be estimated through a binaural localization model. If a sound signal as shown in Fig. 2 is played out to the user in a vehicle, some parts of the audio signal may be perceived in an unpleasant loudness, whereas other parts of the audio signal may be considered to be too low to be correctly perceived by the user. In Fig. 3 an ideally adjusted level of the signal of Fig. 2 is shown. By way of example the signal samples in range 21 should be adapted to a lower signal level, whereas the signals in range 22 should be adapted to a higher signal level for a good perception by the user. Similarly, the signals in range 23 should be output with a strongly decreased signal level.

In the lower part of Fig. 3 the corresponding estimated loudness of the ideally adjusted level in the upper part is shown. When the lower part of Fig. 2 is compared to the lower part of Fig. 3, it can be deduced that a loudness evaluation as shown in Fig. 3 is preferred to the loudness evaluation as shown in Fig. 2. The loudness evaluation of Fig. 3 can be perceived better than the loudness evaluation of Fig. 2. A smoothed, relatively constant loudness is reached and visualized here.

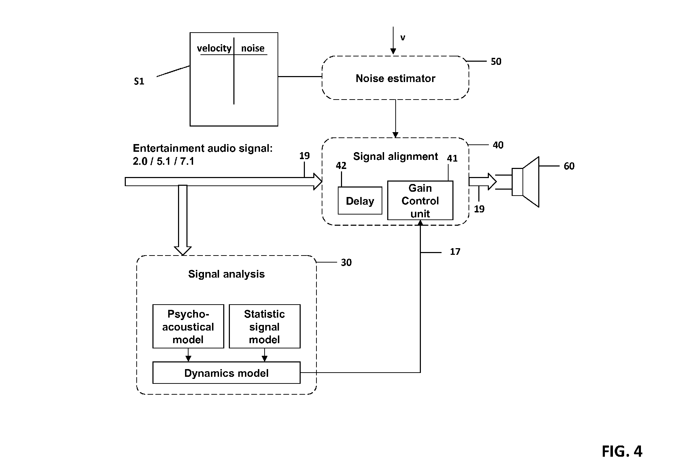

In Fig. 4 a system is shown with which the loudness can be adapted as schematically shown in the embodiment of Fig. 3. The system shown comprises a audio signal analyzing unit 30 in which the loudness of an audio input signal, such as an entertainment audio signal, is determined using a psycho-acoustical localization model of the human hearing and using signal statics. The audio input signal 19 is input into a signal controller 40 comprising a gain control unit 41 and a delay element 42. The gain determined by the gain control unit is controlled using a user interface 50, where it can be determined whether or to which extent the gain determined by the gain determination unit is used for the audio output signal 19 before it is output via a loudspeaker 60 or fed to a post-processing stage. The entertainment or audio input signal can be a 2.0, 5.1 or 7.1 audio signal or another format that is input as audio signal 18 into the audio signal analyzing unit and signal controller 40.

In the signal analyzing unit 30 it is symbolically shown that the loudness is determined based on a psycho-acoustical model of the human hearing and based on signal statistics. The psycho-acoustical model is used to estimate the loudness, localization of sound, and to determine whether noise is present in the audio input signal as a dominant factor, e.g. during a pause or between two tracks. The signal statistics is the second basis for determining or estimating the loudness and for determining whether a pause with noise is present in the audio signal. By way of example the signal strength of the entertainment audio signal can be determined. Based on the psycho-acoustical model alone or in combination with the statistical signal model a loudness adaptation is determined by dynamically determining adaptive time constants as will be described in further detail below.

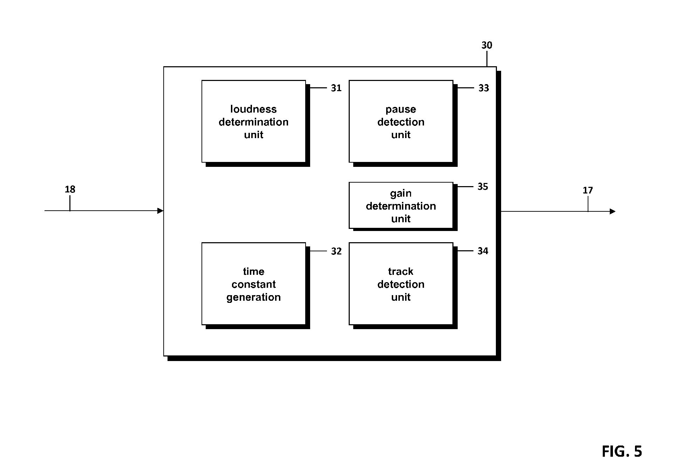

In Fig. 5 a more detailed view of the audio signal analyzing unit 30 is shown. The audio signal analyzing unit comprises a loudness determination unit 31 estimating a loudness of the received audio input signal. The loudness determination unit 31 may determine the loudness with methods known in the art and as described inter alia in ITU-R BS 1770-1. The loudness determination unit may furthermore use a binaural model of the human hearing for determining the loudness and for determining whether and where the audio input signal 18 could be localized by a user when hearing said audio input signal. This binaural model simulates the spatial perception of the audio input signal and allows to determine whether the audio input signal contains mainly noise or any other input signal such as music or speech. The localization of the audio input signal is described in more detail in the documents mentioned earlier in the present application, mainly in EP 1 522 868 A1, in the document of W. Lindemann or in the Audio Engineering Society Convention Paper 5864 mentioned above. This localization technique allows to discriminate noise from other sound signals and helps to avoid that if only noise is detected in the audio input signal, that this noise is output with an increased gain. It also allows to reset the adaptive time constants, when a pause was detected. The loudness determination unit estimates the loudness of the audio input signal using the psycho-acoustical model of the human hearing.

Furthermore, the loudness determination unit 31 can additionally use a statistical signal processing in order to estimate the loudness of the audio input signal or to detect signal pauses. In the statistical analysis of the audio input signal the actual signal level of different samples of the audio input signal is determined. By way of example if the signal level of several consecutive samples of the input signal follows a Gaussian distribution, it can be deduced that the processed samples contain noise and no other audio signal.

The audio signal analyzing unit then uses the result of the loudness estimation for calculating time constants that are introduced into the audio input signal. In Fig. 5 the calculation of the time constants is symbolized by the time constant generator 32.

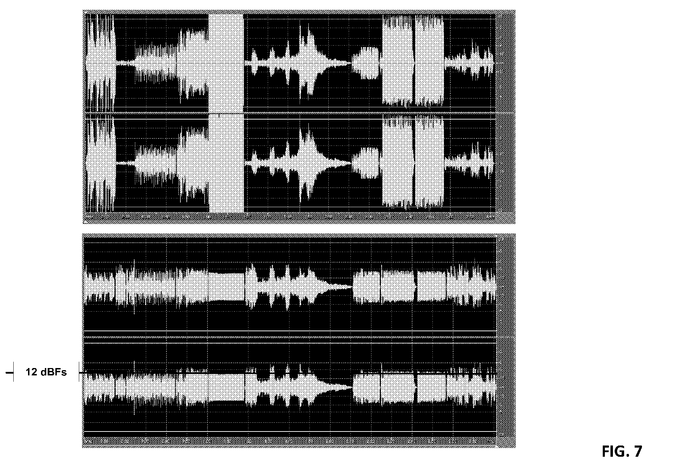

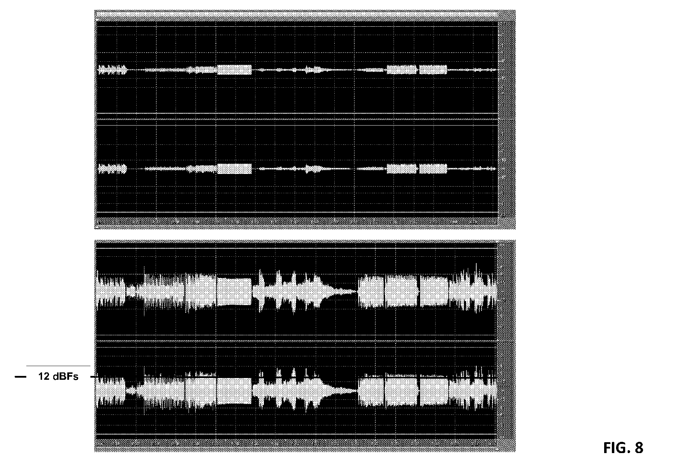

The audio signal analyzing unit 30 further comprises a gain determination unit 35 which adapts the gain of the audio output signal 17. The loudness determination unit 31 provides a loudness for a certain part of the music input signal, e.g. a block containing several samples by emitting a dB loudness equivalent (dBLEQ). The gain determination unit has a predefined signal level which should be met when outputting the audio signal, e.g. -12 dB as shown in Figs. 7 and 8 in the lower part of the Figs or any other signal level threshold. In the gain determination unit the determined loudness is subtracted from the mean signal level to be obtained in order to calculate the gain. By way of example if the determined loudness corresponds to -5 dB and if the target is -12 dB full scale, the gain has to be adapted accordingly by decreasing the gain in order to have an average signal level of about -12 dB.

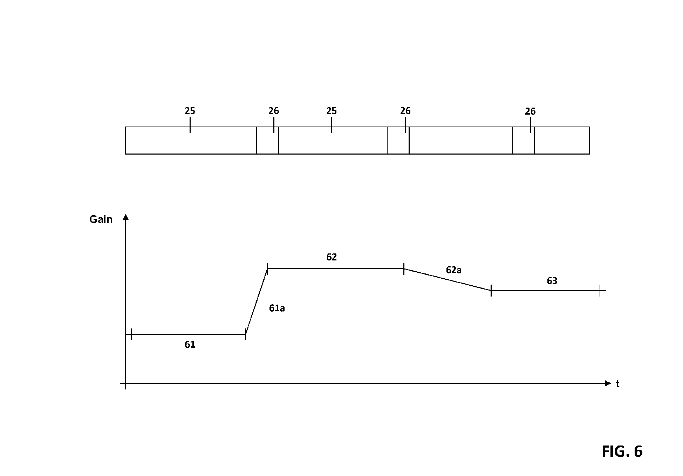

In Fig. 6 different samples 25 of the audio input signals are shown separated by the time constants 26. The time constants 26 indicate how the loudness should be adapted from one sample to the next sample. The time constant could be a raising time constant or a falling time constant. The raising time constant indicates how the signal gain is increased from one sample to the next sample, whereas the falling time constant indicates the gain decrease from one sample to the next sample. The time constants 26 are determined in such a way that the raising time constants can be adapted much more rapidly than the falling time constants. By way of example, if a signal pause is determined between two tracks or within a track, the audio signal level should be not increased in order to avoid the amplification of noise. When a new track starts, high signal levels may occur directly after very low signal levels. The raising time constants of the loudness estimation have to be adapted accordingly in order to avoid that the signal level at the beginning of a new track is heavily increased. The falling time constant in the case of a audio signal level decrease only allow a slower decrease of the signal level compared to the increase. Furthermore, the time constants are adaptive time constants meaning that the longer a track is, the slower the time constants react. This can be valid for the increasing and decreasing time constants. A smoothed loudness estimation guarantees also a loudness estimation in a way like humans perceive loudness. Peaks and dips are smoothed out by the human auditory system. The fact that the time constants are varying slower with the increase time of an audio track helps to maintain the dynamics of the audio signal. However, also when a long runtime of a music signal is reached, a shorter reaction time of increasing loudness guarantees adequate reaction to fast signal increases.

In the lower part of Fig. 6 the gain increase and gain decrease is shown for a music signal over time. For a first block 61 of music samples a first gain is determined as shown. For a following signal block 62 an increased gain is determined followed by signal block 63 with a slightly decreased gain. Based on the loudness adaptation using the time constants a gain for each block is determined, i.e. a target gain for each block. The target gain for block n is then attained in a linear ramp starting from the target gain of the previous block n-1.

If a pause in a track or between two tracks is determined, the time constants may be reset. The pause detection or track detection carried out in the signal analyzing unit 30 is symbolized by the pause detection unit 33 and the track detection unit 34. In the embodiment of Fig. 5 the loudness determination unit 31, the time constant generator 32, the pause and the track detection units 33 and 34, and the gain determination unit 35 are shown as separate units. However, it should be clear to one skilled in the art that the different units may be incorporated into fewer units and that the units may be combined in several units or even in one unit. Furthermore, the signal analyzing unit may be designed by hardware elements or by software or by a combination of hardware and software.

Referring back to Fig. 4 the signal output 17 of the signal analyzing unit is input into a gain control unit 41 which controls the gain of the audio input signal as will be explained further below. The signal control unit 40 furthermore contains the delay element introducing the delay into the audio input signal 18 that is needed for the determination of the gain in the signal analyzing unit. The delay element helps to assure that the signal processed by the signal analyzing unit 30 is actually controlled with the correct time constants corresponding to the audio signal for which they were determined.

The gain control unit 41 helps to determine to which amount a gain determined by the gain determination unit 35 is actually influencing the signal output level. To this end a noise estimator 50 is provided estimating the ambient noise in the vehicle cabin. As can be seen in Fig. 1 the vehicle speed strongly influences the noise in the vehicle cabin. If the vehicle is travelling at a very low velocity or is at rest, a gain adaptation as determined by the gain determination unit may not be considered necessary. If the music output signal should not be influenced by the gain determination unit at all, meaning that no correction as determined in unit 30 is used for the output, then the gain control unit can set the factor by which the output signal is influenced by the calculation carried out in unit 30 to 0%. The noise estimator 50 can receive a vehicle velocity and can access a table 51 in which a relationship between the vehicle velocity and the noise is provided. This table may be a predefined table set by the vehicle manufacturer. Normally, the driver should not be able to adapt the values given in table 51. However, the values given in the table may be changed, e.g. by a software tool with which the sound settings can be adjusted. When the vehicle velocity is higher, the ambient noise may also be at 80 dB(A) as shown in Fig. 1. In this example, then only 25 dB(A) remain if the threshold of 105 dB(A) should not be exceeded. With an ambient noise of 80 dB(A), the loudness of the audio output signal may be dynamically determined by the gain determination unit as described above. The gain determination unit can determine a factor between 0% and 100% based on the ambient noise, this percentage describing by which amount the loudness should be adapted as described above. In an embodiment shown the vehicle velocity is the only variable to determine the ambient noise. However, other factors may be used alone or in combination with the vehicle velocity such as the ambient noise such as the determined by a microphone (not shown).

In Fig. 7 a first example of the automatic loudness adaptation is shown. In the upper part of Fig. 7 the audio input signal 18 before the loudness estimation is shown. As can be seen from the two channels of the audio input signal, the input signals cover different input level ranges. The maximum input level may be 0 dB full scale. In the lower part of Fig. 7 the audio output signal 19 after loudness estimation and gain adaptation is shown. As can be seen from the lower part of Fig. 7, the average signal level is set to -12 dB full scale. At the same time the dynamic structure of the audio signal is preserved.

In Fig. 8 another example is shown in which the input level has a maximum input level of -20 dB full scale. In the lower part of Fig. 8 the audio output signal 19 is shown after loudness estimation and gain adaptation. Again the dynamic structure is preserved and the average signal level is again -12 dB full scale. If the input signal shown in the upper part of Figs. 7 and 8 was output to the user, the user would have to adjust the volume frequently in order to avoid signal levels that are unpleasant high and in order to increase the signal for parts of the audio signal where the signal level is too low for listening.

With the present application this frequent volume adjustment by the user is not necessary anymore, as the system estimates the loudness and automatically and dynamically aligns a gain before output.

## Claims

1. A method for adapting a gain of an audio output signal containing at least two different tracks with different signal level ranges, the method comprising the steps of:
- dynamically determining a perceived loudness of an audio input signal based on a psychoacoustic model of a human hearing,
- dynamically determining a gain of the audio output signal output by a gain determination unit (35) receiving the perceived loudness and outputting the audio output signal with the determined gain, wherein the gain is determined in such a way that said at least two tracks of the audio output signal are output covering a predetermined range of signal levels or loudness range
- estimating an ambient noise in a space to which the audio output signal is output, and
- determining to which extend the gain determined by the gain determination unit influences the audio output signal, wherein the extend by which an audio output is influenced by the gain determination unit, is determined based on the estimated ambient noise.

2. The method according to claim 1, wherein, if the estimated ambient noise is lower than a predefined threshold, the audio output signal is not influenced by the gain determined by the gain determination unit.

3. The method according to claim 1 or 2, wherein the ambient noise is estimated by determining the vehicle velocity, the ambient noise being deduced from the vehicle velocity.

4. The method according to any of the preceding claims, wherein the extent, by which the dynamically determined gain influences the audio output signal increases with an increase of the estimated ambient noise.

5. The method according to any of the preceding claims, wherein each track of the audio input and output signal contains consecutive blocks of music signals, wherein the loudness of each block is determined using a time constant, the time constant describing a change of the loudness from one block to the next block.

6. The method according to claim 5, wherein a raising time constant is used to describe a raising loudness between two consecutive blocks and a falling time constant to describe a falling loudness between two consecutive blocks, wherein the time constants are configured in such a way that the raising time constant allows a faster loudness increase than the falling time constant allows a loudness decrease.

7. The method according to claim 5 or 6, wherein the time constant is an adaptive time constant, wherein the adaptive time constant is adapted in such a way that, at a beginning of a track, the time constant is allowed to vary faster than later during the track.

8. The method according to claim 7, wherein the adaptive time constant is reset when a pause between two tracks is detected, the pause being detected by determining whether the audio input signal can be localized or not using a binaural localization model alone or in combination with a signal statistics model.

9. The method according to any of the preceding claims, further comprising the step of including a delay time into the audio input signal before it is output, wherein the delay time corresponds to the time needed to determine the gain for the audio output signal.

10. A system adapting a gain of an audio output signal containing at least two different tracks with different signal level ranges, the system receiving an audio input signal and outputting the audio output signal with an adapted gain, the system comprising:
- a loudness determination unit (31) dynamically determining a loudness of the audio input signal based on a psychoacoustic model of a human hearing, and
- a gain determination unit (35) receiving the determined loudness and outputting the audio output signal with an adapted gain, wherein the gain determination unit (35) dynamically determines the gain of the audio output signal in such a way, that said at least two tracks of the audio output signal are output covering a predetermined range of signal levels
- an ambient noise estimation unit (50) configured to estimate an ambient noise in a space to which the audio output signal is output,
- a gain control unit (41) configured to determine to which extent the gain determined by the gain determination unit influences the audio output signal, wherein the gain control unit determines the extend by which the audio output signal is influenced by the gain determination unit based on the estimated ambient noise.

11. The system according to claim 10, further comprising a pause detection unit (33) determining a pause between said at least two different tracks or within a track in which noise is the dominant part of audio input signal by determining whether the audio input signal can be localized or not using a simulation of the spatial perception of the audio input signal as perceived by a listener listening to the audio input signal, wherein the gain determination unit (35) decreases the gain in the determined pause.

12. The system according to claim 10 or 11, wherein each track of the audio input and output signal contains consecutive blocks (25) of audio signals, wherein a time constant generation unit (32) determines time constants (26) for said consecutive blocks of the audio input signal, the time constants (26) describing a change of the loudness from one block to the next block, wherein the gain determination unit (35) determines the gain of the audio output signal based on the time constants.

13. The system according to claim 12, wherein the time constant generating unit (32) uses a raising time constant to describe a raising loudness between two consecutive blocks and a falling time constant to describe a falling loudness between two consecutive blocks, wherein the time constant generation unit determines the time constants in such a way that the raising time constant allows a faster gain increase than the falling time constant allows a gain decrease.

14. The system according to claim 12 or 13, wherein the time constant generation unit (32) determines the time constants in such a way that the time constant is an adaptive time constant that, at the beginning of a track, can vary from block to block faster than later during the track.

15. The system according to any of claims 12 to 14, wherein the time constant generation unit (32) resets the time constant when it detects a pause between two tracks.

16. The system according to any of claims 11 to 15, further comprising a delay element (42) introducing a delay time into the audio input signal before it is output as output signal, wherein the delay element introduces the delay time corresponding to the time needed to determine the gain for the audio output signal.

17. The system according to any of claims 10 to 16, wherein the gain control unit is configured to eliminate the influence of the gain determination unit (35) on the audio output signal, when the estimated noise is lower than a predefined threshold.
